# EUROPÄISCHE PATENTANMELDUNG

(11) **EP 1 089 423 A2**
(43) Veröffentlichungstag der Anmeldung: **04.04.2001**
(21) Anmeldenummer: 00810714.6
(22) Anmeldetag: 11.08.2000
(51) Int. Cl.: H02M 7/48

(54) **Schaltung und Verfahren zur Einschaltentlastung von abschaltbaren Leistungsschaltern**

(30) Priorität: 04.09.1999 DE 19942258
(71) Anmelder: ABB Industrie AG, 5401 Baden (CH)
(72) Erfinder: Bernet, Steffen, Dr., 69245 Bammental (DE); Brückner, Thomas, 01809 Heidenau (DE); Steimer, Peter, 5424 Unterehrendingen (CH); Steiner, Michael, 68723 Schwetzingen (DE)
(74) Vertreter: ABB Patent Attorneys

(57) **Zusammenfassung**

Die vorliegende Erfindung bezieht sich auf eine Schaltung und ein Verfahren zur Einschaltentlastung von abschaltbaren Leistungsschaltern in Dreipunkt-Stromrichtern. Durch dieses Einschaltentlastungsnetzwerk wird eine Begrenzung des Stromsanstiegs di/dt im Dreipunkt-Stromrichter mit abschaltbaren Leistungsschalter-Hauptschaltern gewährleistet und dabei ein prinzipbedingter Umsatz von Einschaltentlastungsnetzwerkenergie in Wärme vermieden. Auch wird der Kurzschlussstromanstieg im Kurzschlussfall der Hauptschalter gewährleistet. Zu diesem Zweck ist in einem oberen und einem unteren Brückenzweig jeweils ein Einschaltentlastungsnetzwerk ausgebildet, das eine Einschaltentlastungsdrosselspule, einen Überspannungsbegrenzungskondensator sowie einen Hilfsschalter bestehend aus beispielsweise einem abschaltbaren Leistungsschalter sowie einer antiparallelen Diode aufweist. Diese Elemente sind derart verschaltet, dass im Falle eines Ausschaltens eines abschaltbaren Leistungsschalter-Hauptschalters eine Kommutierung derart erfolgt, dass kein Umsatz der Energie in Wärme erfolgt. Durch entsprechende Steuerung der Schaltzeitpunkte der abschaltbaren Leistungsschalter wird ein langfristiger Ladungsausgleich an den Überspannungsbegrenzungskondensatoren erreicht.

## Beschreibung

### Technisches Gebiet

Die vorliegende Erfindung bezieht sich auf das Gebiet der von einem Spannungszwischenkreis gespeisten Dreipunkt-Stromrichter. Sie betrifft eine Schaltung und ein Verfahren zur Einschaltentlastung von abschaltbaren Leistungsschaltern in Dreipunkt-Stromrichtern.

### Stand der Technik

Die Topologie des Neutral Point Clamped- bzw. NPC-Dreipunkt-Stromrichters ist schon seit langer Zeit allgemein bekannt. Für den Bereich großer Leistungen wird sie sowohl in elektrischen Antrieben als auch in Filter- und Kompensationsanlagen industriell angewendet. Dabei finden als abschaltbare Leistungsschalter unter anderem Integrated-Gate-Commutated-Thyristoren bzw. integrierte Gate-kommutierte Thyristoren bzw. IGCTs als Hauptschalter Anwendung.

Im Gegensatz zur Anwendung von Insulated-Gate-Bipolar-Transistoren bzw. Bipolartransistoren mit isolierter Steuerelektrode bzw. IGBTs muß beim Einsatz von IGCT-Bauelementen der Stromanstieg di/dt durch die Bauelemente beim Einschalten, d.h. dem aktiven Einschalten eines IGCT verbunden mit dem gleichzeitigen passiven Ausschalten eines weiteren Leistungshalbleiters (im allgemeinen einer Diode) begrenzt werden. Zu diesen Zweck werden Turn-On-Snubber- bzw. Einschaltschutzbeschaltungen bzw. Einschaltentlastungsnetzwerke in der Schaltung angeordnet, welche die di/dt-Begrenzung gewährleisten und dadurch in der Regel die Schaltverluste im einschaltenden IGCT und der ausschaltenden Diode reduzieren.

Die Begrenzung des Stromanstieges wird prinzipiell durch zu den Schaltern in Reihe geschaltete Spulen erreicht. Stets sind zusätzliche aktive und/oder passive Bauelemente erforderlich.

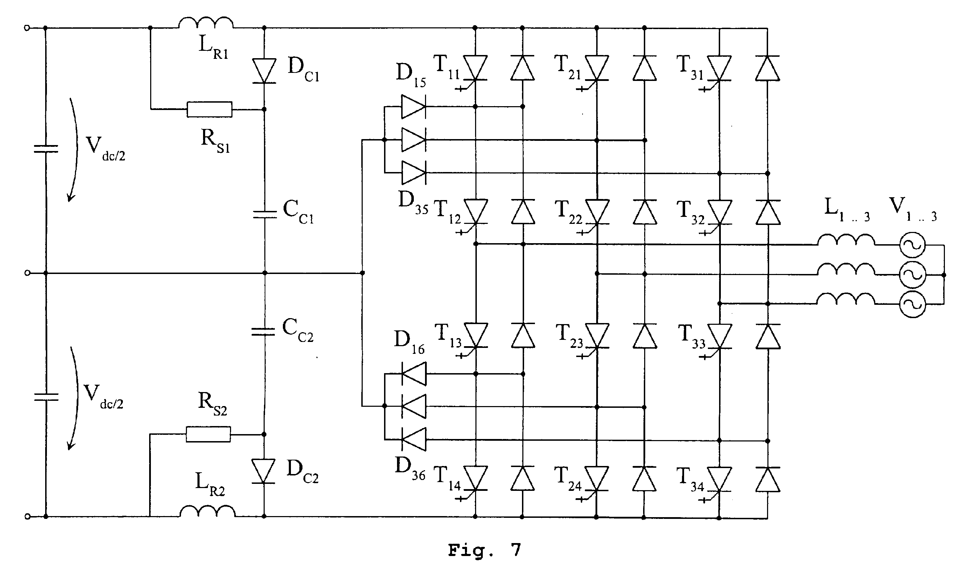

In konventionellen Einschaltentlastungsnetzwerken, für die eine beispielhafte Schaltung in Fig. 7 dargestellt ist, wird die gesamte im Snubber bzw. Einschaltentlastungsnetzwerk gespeicherte Energie über Widerstände in Wärme umgesetzt. In Stromrichtern hoher Leistung können dadurch erhebliche Verluste entstehen. Zwar ist eine Rückspeisung der Snubber- bzw. Einschaltentlastungsnetzwerkenergie in den Gleichspannungszwischenkreis über einen Gleichspannungssteller in den meisten Fällen möglich, erfordert jedoch einen hohen schaltungstechnischen Aufwand und ist wiederum mit Verlusten im Gleichspannungssteller verbunden.

Für die Topologie von Zweipunkt-Stromrichtern ist aus der DE 196 36 248 Cl auch ein für IGBT vorgesehenes Einschaltentlastungsnetzwerk bekannt, das die Einschaltentlastungsnetzwerkenergie direkt in den Zwischenkreis zurückspeist. Der Vorteil dieses Einschaltentlastungsnetzwerks ist, daß prinzipbedingt keine Einschaltentlastungsnetzwerkenergie in Wärme umgesetzt wird.

Jedoch ist keinerlei Schaltung oder Verfahren zur Schaltentlastung von abschaltbaren Leistungsschaltern, insbesondere IGCT in Dreipunkt-Stromrichtern bekannt, in dem auf einfache Weise ein Umsatz von Einschaltentlastungsnetzwerkenergie in Wärme vermieden wird, d.h. ohne eine Verkomplizierung der Schaltung und einen erhöhten Bauteilaufwand.

### Darstellung der Erfindung

Daher ist es Aufgabe der vorliegenden Erfindung, ein Einschaltentlastungsnetzwerk und ein geeignetes Verfahren zur Einschaltentlastung von abschaltbaren Leistungsschaltern in Dreipunkt-Stromrichtern auszubilden, durch das eine Begrenzung des Stromanstieges di/dt im Dreipunkt-Stromrichter mit abschaltbaren Leistungsschaltern-Hauptschaltern gewährleistet und dabei ein prinzipbedingter Umsatz von Einschaltentlastungsnetzwerkenergie in Wärme vermieden wird.

Ferner soll die Schaltung zur Lösung dieser Aufgabe gegenüber konventionellen Einschaltentlastungsnetzwerken, insbesondere solchen mit Rückspeisung der Einschaltentlastungsnetzwerkenergie über einen Gleichspannungssteller, keinen erhöhten bzw. einen reduzierten Gesamtaufwand an Bauelementen aufweisen. Zusätzlich ist durch die Anordnung der Spulen der Schutz für den Kurzschlußfall der Hauptschalter zu gewährleisten, indem der Kurzschlußstromanstieg und die Höhe des Kurzschlussstromes begrenzt wird.

Erfindungsgemäss wird diese Aufgabe durch die in Anspruch 1, 2, 4 bzw. 5 angegebenen Merkmale gelöst.

Durch das erfindungsgemässe Einschaltentlastungsnetzwerk sowie das zugehörige Verfahren zur Einschaltentlastung von abschaltbaren Leistungsschaltern, beispielsweise IGCT in Dreipunkt-Stromrichtern wird auf einfache und kostengünstige Weise vermieden, dass die im Einschaltentlastungsnetzwerk umgesetzte Energie in Wärme umgewandelt wird, der Stromanstieg di/dt begrenzt wird und zudem auch ein Anstieg des Kurzschlussstroms begrenzt wird.

### Kurze Beschreibung der Zeichnung

Weitere Aufgaben, Merkmale und Vorteile der vorliegenden Erfindung werden aus der nachstehenden Beschreibung bevorzugter Ausführungsbeispiele der Erfindung in Verbindung mit der Zeichnung offensichtlich.

Es zeigen:
- Fig. 1: eine Darstellung eines ersten Ausführungsbeispiels eines erfindungsgemässen Einschaltentlastungsnetzwerks,
- Fig. 2: eine Darstellung eines alternativen Ausführungsbeispiels eines erfindungsgemässen Einschaltentlastungsnetzwerks,
- Fig. 3: Strom- und Spannungsverläufe in dem Einschaltentlastungsnetzwerk gemäss Fig. 1 bei einer kapazitiven Kommutierung vom Typ 1,
- Fig. 4: Strom- und Spannungsverläufe in dem Einschaltentlastungsnetzwerk gemäss Fig. 1 bei einer kapazitiven Kommutierung vom Typ 2,
- Fig. 5: Strom- und Spannungsverläufe in dem Einschaltentlastungsnetzwerk gemäss Fig. 1 bei einer kapazitiven Kommutierung vom Typ 3,
- Fig. 6: Strom- und Spannungsverläufe in dem Einschaltentlastungsnetzwerk gemäss Fig. 1 bei einer induktiven Kommutierung,
- Fig. 7: eine Darstellung eines herkömmlichen Einschaltentlastungsnetzwerks

In den Figuren bezeichnen gleiche Bezugszeichen gleiche Elemente.

### Wege zur Ausführung der Erfindung

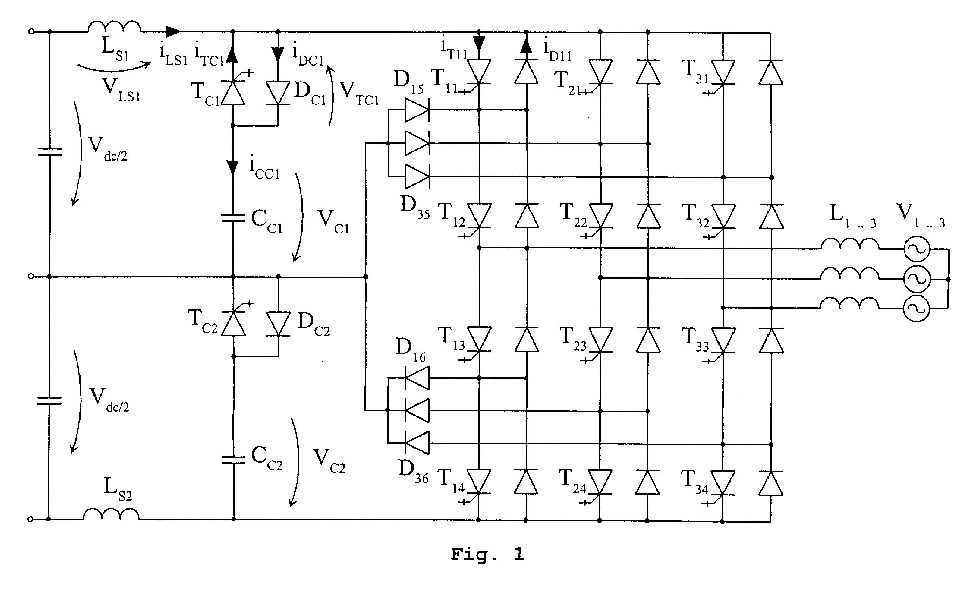

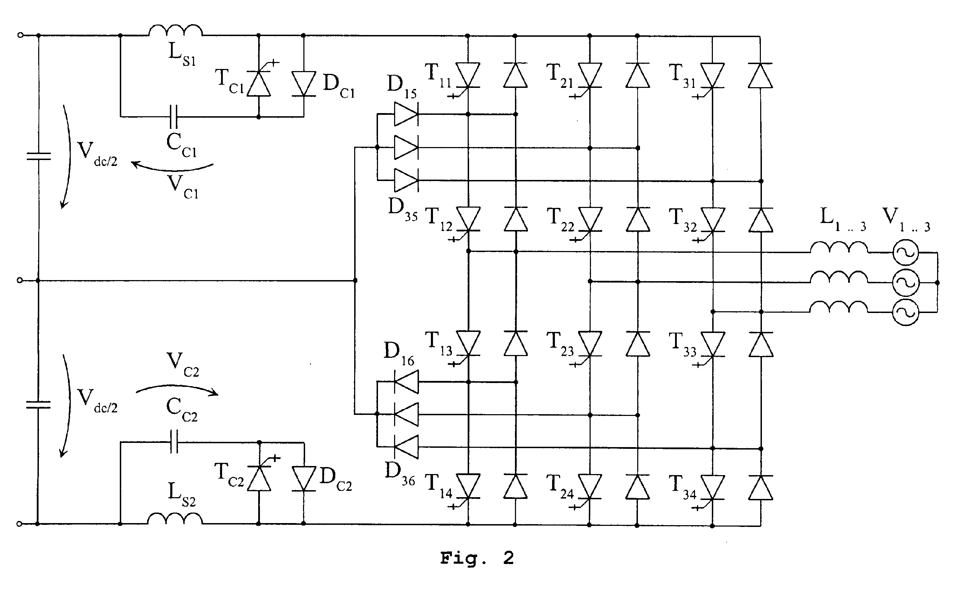

Im folgenden werden zunächst zwei alternative Ausführungsbeispiele für erfindungsgemässe Einschaltentlastungsnetzwerke unter Bezugnahme auf Fig. 1 und 2 beschrieben.

Die Erläuterung der Erfindung erfolgt unter Bezugnahme auf Schaltungen und Verfahren, in denen beispielhaft IGCTs (Integrated-Gate-Commutated-Thyristoren) als abschaltbare Leistungsschalter verwendet werden und die Schaltung 3 Phasen aufweist. Jedoch können auch andere abschaltbare Leistungsschalter, beispielsweise IGBTs (Insulated-Gate-Bipolartransistoren) oder SiC-MOSFETs (SiC-Metall-Oxid-Halbleiter-Feldeffekttransistoren) verwendet werden und die Schaltung auch N Phasen aufweisen, wobei N = 1, 2, 3, ... ist.

Eine erfindungsgemässe Schaltung gemäss Fig. 1 bzw. Fig. 2 umfasst jeweils zwei getrennte Einschaltentlastungsnetzwerke für eine obere und eine untere Brückenhälfte. Ein aus abschaltbaren Leistungsschaltern, hier IGCT, gebildeter Dreipunkt-Stromrichter wird hierbei aus zwei Gleichspannungsquellen mit jeweils einer Gleichspannung V_{dc/2} gespeist. In den vorliegenden Ausführungsbeispielen gemäss Fig. 1 bzw. Fig. 2 umfassen diese Gleichspannungsquellen V_{dc/2} jeweils einen Kondensator im Spannungszwischenkreis, die in Reihe geschaltet sind und über die jeweils eine halbe Zwischenkreisspannung V_{dc/2} abfällt. Zwischen den Klemmen der zwei Gleichspannungsquellen V_{dc/2}, d.h. Potentialpunkte + und - sind jeweils als Zweigpaare zwei in Reihe geschaltete Paare von IGCTs T₁₁, T₁₂ bis T₃₁ bis T₃₂ sowie ihnen antiparallel geschaltete Dioden vorgesehen, die die drei Stränge des Dreipunkt-Stromrichters mit den Wechselspannungsanschlüssen V₁ bis V₃ jeweils an den gemeinsamen Verbindungspunkten der Zweigpaare bilden. Zusätzlich sind die zwischen einem Potentialpunkt 0, der zwischen den Kondensatoren der zwei Gleichspannungsquellen V_{dc/2} liegt und zwischen den IGCTs der Reihenschaltung in der jeweiligen Brückenhälfte Dioden D₁₅ bis D₃₅ und D₁₆ bis D₃₆ ausgebildet. Weiterhin umfassen die Einschaltentlastungsnetzwerke für die obere Brückenhälfte im Gleichspannungszwischenkreis, d.h. zwischen der Zuleitung zu den mit dem Potentialpunkt + verbundenen IGCTs T₁₁, T₂₁, T₃₁ und dem Potentialpunkt 0 zwischen den beiden Kondensatoren der zwei Gleichspannungsquellen V_{dc/2} sowie für die untere Brückenhälfte im Gleichspannungszwischenkreis zwischen dem Potentialpunkt 0 und der Zuleitung zu den mit dem Potentialpunkt - verbundenen IGCTs T₁₄, T₂₄, T₃₄ Snubber- bzw. Einschaltentlastungsdrosselspulen Lsi bzw. L_{S2}, Hilfsschalter T_{C1} und D_{C1} bzw. T_{C2} und D_{C2} sowie Clamp-Kondensatoren C_{C1} bzw. C_{C2}. Im Gegensatz zum in Fig. 7 gezeigten herkömmlichen Einschaltentlastungsnetzwerk sind die beiden (oberen und unteren) Einschaltentlastungsnetzwerke gemäss Fig. 1 nicht symmetrisch zum Potentialpunkt 0 ausgebildet. Es ist jedoch auch möglich, die Einschaltentlastungsnetzwerke für die obere und die untere Brückenhälfte symmetrisch anzuordnen, indem im oberen oder unteren Einschaltentlastungsnetzwerk in der Reihenschaltung der Hilfsschalter T_{C1} und D_{C1} bzw. T_{C2} und D_{C2} mit den Überspannungsbegrenzungskondensatoren C_{C1} bzw. C_{C2} die Elemente in ihrer Reihenfolge vertauscht werden.

Im Ausführungsbeispiel gemäss Fig. 1 ist in der oberen Brükkenhälfte zwischen dem Potentialpunkt + und Hauptschaltern (ICGTs) T₁₁ bis T₃₁ sowie zugehörigen antiparallelen Dioden D₁₁ bis D₃₁ in der Zuleitung eine Einschaltentlastungsdrosselspule L_{S1} angeordnet. Zwischen der Einschaltentlastungdrosselspule L_{S1} und dem IGCT T₁₁ ist in einem Verbindungszweig zum Potentialpunkt 0 ein Hilfsschalter T_{C1}, D_{C1} in Reihe mit einem Überspannungsbegrenzungs- bzw. Clamp-Kondensator C_{C1} ausgebildet. In der unteren Brückenhälfte werden dieselben Beschaltungselemente verwendet, jedoch ist hier der Hilfsschalter T_{C2}, D_{C2} an seinem einen Anschluss mit dem Potentialpunkt 0 und an seinem anderen Anschluss mit einem Clamp-Kondensator C_{C2} verbunden. In der Zuleitung vom Potentialpunkt - ist zwischen dem Potentialpunkt - und dem IGCT T₁₄ eine Einschaltentlastungsdrosselspule L_{S2} ausgebildet. Der Clamp-Kondensator C_{C2} ist wiederum mit einem Punkt in der Zuleitung zwischen der Einschaltentlastungsdrosselspule L_{S2} und dem IGCT T₁₄ verbunden.

Im Unterschied zum Ausführungsbeispiel gemäss Fig. 1 weist das Ausführungsbeispiel gemäss Fig. 2 zwei spiegelsymmetrisch zum Potentialpunkt 0 ausgebildete Einschaltentlastungsnetzwerke auf. Es wird hier der Kürze halber nur auf Unterschiede in der Struktur im Vergleich zum Ausführungsbeispiel gemäss Fig. 1 eingegangen und aufgrund des spiegelsymmetrischen Aufbaus der zwei Einschaltentlastungsnetzwerke nur das Einschaltentlastungsnetzwerk für die obere Brückenhälfte beschrieben. In diesem Ausführungsbeispiel gemäss Fig. 2 ist das Einschaltentlastungsnetzwerk in der Zuleitung vom Potentialpunkt + zum IGCT T₁₁ ausgebildet. Es umfasst eine Parallelschaltung aus einer Einschaltentlastungsdrosselspule Lsi und einer Reihenschaltung aus einem Clamp-Kondensator C_{C1} und einem Hilfsschalter T_{C1}, D_{C1}.

In den Fig.en 1 und 2 sind die Hilfsschalter T_{C1}, D_{C1} bzw. T_{C2}, D_{C2} als aus einer Parallelschaltung aus einem IGCT T_{C1} bis T_{C2} und einer antiparallelen Diode D_{C1} bzw. D_{C2} bestehend dargestellt. Die Hilfsschalter T_{C1} und D_{C1} sowie T_{C2} und D_{C2} können-vorteilhaft sowohl durch rückwärts leitfähige IGCTs als auch durch IGCTs mit diskreten antiparallelen Dioden (Inversdioden) oder durch IGBTs mit Inversdioden realisiert werden. Es sind somit für den Fachmann auch andere alternative Ausführungsformen als die in den Fig.en 1 und 2 gezeigten denkbar.

Die zusätzlichen passiven Elemente beider Schaltungsvarianten gemäss Fig. 1 und 2 im Gegensatz zu einem hart schaltenden Dreipunkt-Spannungswechselrichter sind jeweils die Clamp-Kondensatoren C_{C1} und C_{C2}, sowie Einschaltentlastungsdrosselspulen L_{S1} und L_{S2}. Hierbei werden Clamp-Spannungen V_{C1} und V_{C2}, die über die Clamp-Kondensatoren C_{C1} bzw. C_{C2} abfallen, auf einem Wert zwischen 1.2*V_{dc/2} und 1.4*V_{dc/2} (in der Schaltung gemäss Fig. 2 auf einen Wert zwischen 0.2*V_{dc/2} und 0.4*V_{dc/2}) nahezu konstant gehalten, wobei V_{dc/2} die halbe Zwischenkreisspannung darstellt, die über die obere bzw. untere Brückenhälfte abfällt.

Im folgenden wird nun genauer auf die Steuerung der in Fig. 1 bzw. Fig. 2 dargestellten Schaltungen, insbesondere der Einschaltentlastungsnetzwerke eingegangen.

Prinzipiell sind die Erläuterungen, die hier nur zu Fig. 1 erfolgen, auf Fig. 2 übertragbar. Jedoch ist Fig. 2 gegenüber Fig. 1 über die Vermeidung einer Umsetzung von Energie im Einschaltentlastungsnetzwerk hinaus auch dahingehend vorteilhaft, dass der Clamp-Kondensator bedingt durch den Schaltungsaufbau gemäss Fig. 2 einer reduzierten Spannungsbeanspruchung ausgesetzt ist.

Die Schaltung gemäss Fig. 1 bzw. Fig. 2 wird so gesteuert, daß bei Kommutierungen vom oberen Brückenzweig bzw. Potentialpunkt bzw. Pol + auf den Potentialpunkt bzw. Pol 0 und zurück (+ ↔ 0) das obere Entlastungsnetzwerk, für Kommutierungen vom Potentialpunkt bzw. Pol 0 auf den unteren Brückenzweig bzw. den Potentialpunkt bzw. Pol - und zurück (0 ↔ -) das untere Entlastungsnetzwerk genutzt wird. Eine Kommutierung ist hierbei eine Übergabe des Stroms vom stromführenden auf einen folgenden Zweig, wobei während der Kommutierungszeit beide Zweige Strom führen. Bei Kurzschlüssen in den Brückenzweigen oder an der Last gewährleistet die jeweilige Einschaltentlastungsdrosselspule L_{S1} bzw. L_{S2} eine Begrenzung des Kurzschlußstromanstieges sowie des Kurzschlußstromes des IGCT-Stromrichters.

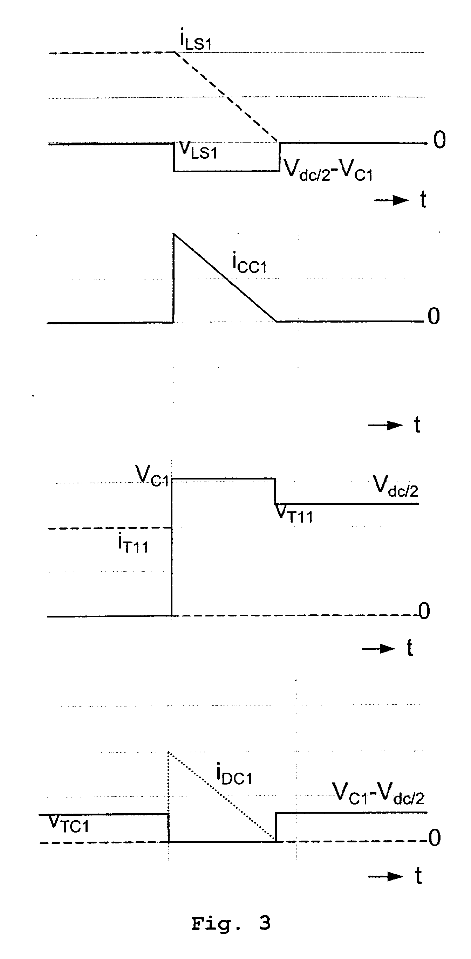

Die Kommutierungen lassen sich je nach Leistungsgradienten der Momentanleistung der betrachteten Stromrichterphase in eine Kommutierung mit positivem Leistungsgradienten und eine Kommutierung mit negativem Leistungsgradienten unterscheiden. Bei Kommutierungen mit positivem Leistungsgradienten, die im folgenden als induktive Kommutierungen bezeichnet werden, ist die Momentanleistung am Ausgang der Stromrichterphase nach der Kommutierung größer als vor der Kommutierung. Bei Kommutierungen mit negativem Leistungsgradienten, die im folgenden als kapazitive Kommutierungen bezeichnet werden, ist die Momentanleistung nach der Kommutierung kleiner als vor der Kommutierung. Die folgende Beschreibung der Kommutierungsvorgänge einschließlich der Fig. 3 bis 6 bezieht sich auf die Schaltung gemäss Fig. 1. Sie ist jedoch jederzeit auch auf die Schaltung gemäss Fig.2 übertragbar.

Bei kapazitiven Kommutierungen schaltet ein IGCT den Phasenstrom aktiv ab. Infolgedessen kommutiert der Strom sehr schnell vom aktiv ausschaltenden IGCT zu einer den Strom übernehmenden Diode im Wechselrichter.

Ein Beispiel für einen derartigen Vorgang ist die Kommutierung des Phasenstromes der Phase 1 von einem Hauptschalter (IGCT) T₁₁ auf eine Diode D₁₅. Dabei wird das Einschaltentlastungsnetzwerk in der oberen Brückenhälfte wirksam. Die wesentlichen Strom- und Spannungsverläufe sind in Fig. 3 dargestellt. Zur Vereinfachung wird bei allen folgenden Erläuterungen angenommen, daß die Phasen 2 und 3 mit dem Minuspol des Wechselrichters verbunden sind. Die beschriebenen Betriebsverfahren sind jedoch in gleicher Weise auf alle möglichen Zustände des IGCT-Dreipunkt-Wechselrichters anwendbar.

Die Kommutierung vom Hauptschalter (IGCT) T₁₁ auf die Diode D₁₅ wird gestartet, indem der Hauptschalter (IGCT) T₁₁ ausgeschaltet wird. Dadurch kommutiert der Phasenstrom nahezu augenblicklich auf die Diode D₁₅. Der Strom in der Einschaltentlastungsdrosselspule L_{S1} kommutiert zeitgleich in die antiparallele Diode D_{C1} des Hilfsschalters und den Clamp-Kondensator C_{C1}. Wie auch im konventionellen Einschaltentlastungsnetzwerk schaltet der Hauptschalter T₁₁ gegen eine erhöhte Spannung, hier die Clamp-Spannung V_{C1}, die über den Clamp-Kondensator C_{C1} abfällt, ohne Schaltentlastung aus. Der Spulenstrom i_{LS1} wird durch die Spannungsdifferenz zwischen der halben Zwischenkreisspannung V_{dc/2} und der Clamp-Spannung V_{C1} nahezu linear abgebaut, wobei die vor dem Schaltvorgang des IGCT T₁₁ in der Spule L_{S1} gespeicherte Energie des ausgeschalteten Phasenstromes in den Clamp-Kondensator C_{C1} transferiert wird. Erreicht der Strom i_{DC1} durch die Diode D_{C1} und der Strom i_{CC1} durch den Clamp-Kondensator C_{C1} den Wert Null, schaltet die Diode Dci während eines Reverse-Recovery- bzw. Sperrverzögerungs-Prozesses passiv aus und der kapazitive Kommutierungsvorgang einschließlich des Stromabbaus in Einschaltentlastungsdrosselspule L_{S1} ist vollständig abgeschlossen.

Die Ladungsbilanz des betreffenden Clamp-Kondensators C_{C1} ist für die beschriebene kapazitive Kommutierung, die im folgenden als kapazitive Kommutierung vom Typ 1 bezeichnet wird, positiv, d.h. dem Clamp-Kondensator C_{C1} wird Ladung zugeführt.

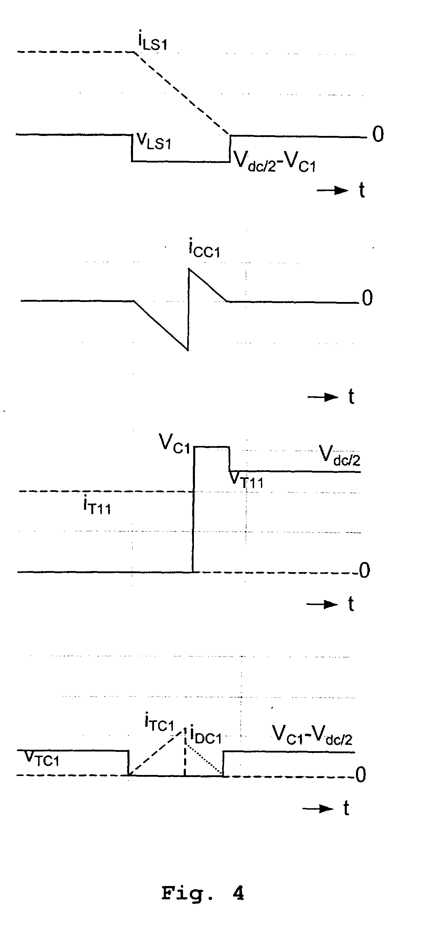

Um die Clamp-Spannung V_{C1} langfristig konstant zu halten, können kapazitive Kommutierungen von Typ 2 eingeführt werden. Die wesentlichen Strom- und Spannungsverläufe sind in Fig. 4 dargestellt.

Die Kommutierung wird gestartet, indem der Hilfsschalter T_{C1} aktiv eingeschaltet wird. Damit liegt eine negative Spannung V_{LS1} in Höhe der Differenz zwischen der halben Zwischenkreisspannung V_{dc/2} und der Clamp-Spannung V_{C1} über der Einschaltentlastungsdrosselspule L_{S1} an. Der Spulenstrom i_{LS1} wird nahezu linear abgebaut und ein negativer Strom i_{CC1} durch den Clamp-Kondensator C_{C1} wird in gleicher Weise aufgebaut. Ist der Betrag des Stromes i_{CC1} auf einen bestimmten Teil des durch den IGCT T₁₁ auszuschaltenden Phasenstromes angewachsen (typischerweise auf einen Wert, der größer ist, als die Hälfte des vom IGCT T₁₁ abzuschaltenden Phasenstroms), wird der IGCT T₁₁ ausgeschaltet. Der überschüssige Spulenstrom, die Differenz aus dem abzuschaltenden Phasenstrom und dem Betrag des Stromes i_{CC1} zum Zeitpunkt des IGCT-Ausschaltvorganges, kommutiert dabei nahezu augenblicklich in die antiparallele Hilfsdiode D_{C1}, wodurch der Hilfsschalter T_{C1} bei Nullstrom als Zero Current Switch bzw. Nullstromschalter ausgeschaltet wird.

Erreicht der Strom i_{CC1} nach dem linearen Stromabfall den Wert Null, so schaltet die Diode D_{C1} während eines Reverse-Recovery-bzw. Sperrverzögerungs-Prozesses passiv aus. Damit ist der Kommutierungsvorgang abgeschlossen. Der IGCT T₁₁ schaltet auch in diesem Fall ohne Schaltentlastung gegen die Clamp-Spannung V_{C1} aus.

Durch Verschiebung des Ausschaltzeitpunktes des Hauptschalters IGCT T₁₁ ist es möglich, die Ladungsbilanz des Clamp-Kondensators C_{C1} zu beeinflussen. Damit kann für diese Kommutierung eine negative Ladungsbilanz eingestellt werden, d.h. dem Clamp-Kondensator C_{C1} werden Ladungen entnommen, welche die positive Ladungsbilanz einer kapazitiven Kommutierung vom Typ 1 ausgleichen können.

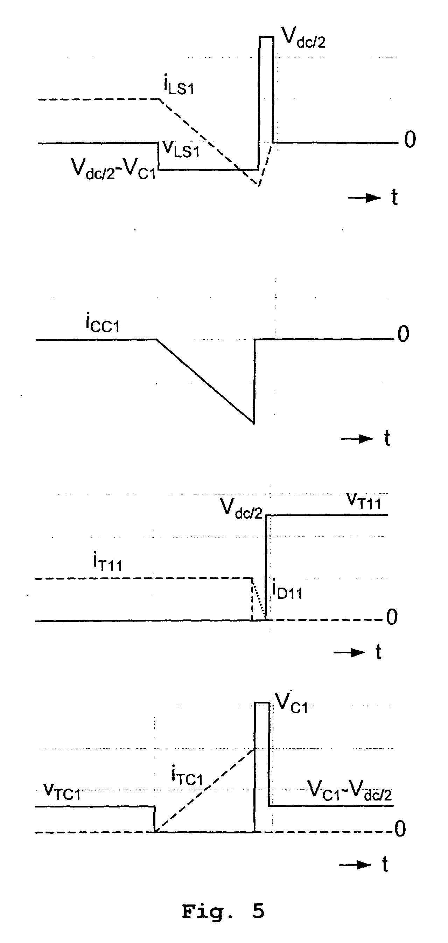

Wird der IGCT T₁₁ erst ausgeschaltet, wenn der Strom i_{CC1} durch den Clamp-Kondensator C_{C1} den Wert des auszuschaltenden Phasenstromes bereits überschritten hat, so schaltet der Hilfsschalter T_{C1} nicht mehr passiv während der Leitphase seiner antiparallelen Diode D_{C1} aus (Kapazitive Kommutierung Typ 3). Typische Strom- und Spannungsverläufe sind in Fig. 5 dargestellt.

Der Hilfsschalter T_{C1} muß in diesem Fall aktiv und ohne Schaltentlastung gegen die Clamp-Spannung V_{C1} ausgeschaltet werden, wobei sein Strom auf D₁₅ und D₁₁ (die antiparallele Diode zu T₁₁) kommutiert und durch die halbe Zwischenkreisspannung V_{dc/2} linear abgebaut wird. Dadurch ist es möglich, die positive Ladungsbilanz des Clamp-Kondensators C_{C1} aus mehreren vorangegangenen Kommutierungen mit gleichem Phasenstrom innerhalb nur einer Kommutierung auszugleichen. Werden der Hauptschalter T₁₁ und der Hilfsschalter T_{C1} zeitgleich bzw. der Hauptschalter T₁₁ geringfügig nach dem Hilfsschalter T_{C1} ausgeschaltet, so läuft der Ausschaltvorgang des Hauptschalters T₁₁ verlustarm bei Zero Current Switching bzw. Nullstromschalten ab.

Die Reduzierung der Clamp-Spannung V_{C1} durch kurzzeitiges Einschalten des Hilfsschalters T_{C1} kann prinzipiell nicht nur in Verbindung mit einer kapazitiven Kommutierung (Typ 3), sondern auch zu beliebigen Zeitpunkten außerhalb von Kommutierungen und in jeder beliebigen Höhe realisiert werden.

Die vorstehend beschriebenen verschiedenen Typen von kapazitiven Kommutierungen werden je nach vorliegenden Phasenströmen unterschiedlich eingesetzt. So werden bei grossen effektiven Phasenströmen die Schaltungen derart betrieben, dass bei kleinen momentanen Phasenströmen, d.h. Strömen, die kleiner als *Î*_{*Phase*}*/2* sind, kapazitive Kommutierungen vom Typ 1 eingesetzt, während bei grossen momentanen Phasenströmen kapazitive Kommutierungen vom Typ 2 angewendet werden. Dabei werden die Ausschaltzeitpunkte der Hauptschalter mittels einer Regelung durch eine nicht gezeigte Steuereinrichtung derart eingestellt, dass ein langfristiger Ladungsausgleich an den Clamp-Kondensatoren C_{C1} und C_{C2} erreicht wird.

Bei kleinen effektiven Phasenströmen hingegen werden die Schaltungen so betrieben, dass unabhängig vom Momentanwert des Phasenstroms kapazitive Kommutierungen vom Typ 1 eingesetzt werden, sofern sich die Clamp-Spannungen V_{C1} und V_{C2} unterhalb eines Grenzwerts befinden. Erreicht die Clamp-Spannung diesen Grenzwert, so wird die nächste kapazitive Kommutierung unter Beteiligung des entsprechenden Clamp-Kondensators als kapazitive Kommutierung vom Typ 3 so durchgeführt, dass die Clamp-Spannung damit auf ihren Sollwert zurückgeführt wird.

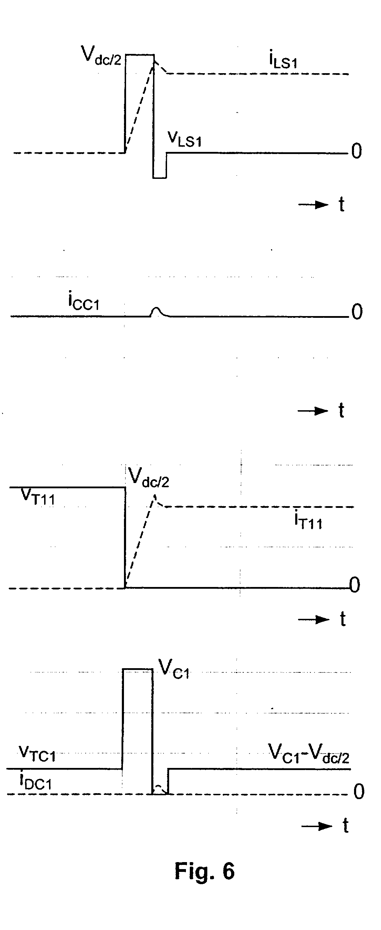

Bei induktiven Kommutierungen geht der Strom von einer Diode auf einen aktiv einschaltenden IGCT über. Die Einschaltentlastungsnetzwerke treten dabei in Erscheinung, indem die entsprechende Einschaltentlastungsdrosselspule L_{S1} bzw. L_{S2} den Stromanstieg begrenzt. Ein solcher Vorgang ist zum Beispiel die Kommutierung des Phasenstromes von der Diode D₁₅ auf den Hauptschalter T₁₁. Hierbei wird die Einschaltentlastungsdrosselspule L_{S1} in der oberen Brückenhälfte wirksam. Wichtige Strom- und Spannungsverläufe sind in Fig. 6 dargestellt. Wird der Hauptschalter T₁₁ eingeschaltet, fällt damit die halbe Zwischenkreisspannung V_{dc/2} über die Einschaltentlastungsdrosselspule L_{S1} ab und der Phasenstrom kommutiert linear von der Diode D₁₅ auf den Hauptschalter T₁₁. Die Diode D₁₅ schaltet während eines Reverse-Recovery- bzw. Sperrverzögerungs-Prozesses passiv aus. Da der Rückstrom der Diode D₁₅ schneller abreißt als der Strom i_{LS1} in der Einschaltentlastungsdrosselspule L_{S1} bei einer Spannung von V_{LS1}=-V_{C1}+V_{dc/2} abgebaut werden kann, kommutiert ein Teil des Spulenstromes i_{LS1} in die Diode D_{C1} und den Clamp-Kondensator C_{C1}. Damit wird ein Teil der zum Zeitpunkt des Diodenrückstromabrisses von der Diode D₁₅ in der Einschaltentlastungsdrosselspule Lsi gespeicherten Energie in den Clamp-Kondensator C_{C1} transferiert. Auch die induktive Kommutierung verursacht somit eine positive Ladungsbilanz am Clamp-Kondensator C_{C1}. Durch die Begrenzung des Stromanstieges di/dt während der Kommutierung werden die Einschaltverluste des Hauptschalters T₁₁ wie auch die Ausschaltverluste der Diode D₁₅ reduziert.

Den langfristigen Ladungsausgleich an den Clamp-Kondensatoren C_{C1} und C_{C2} gewährleistet eine Regelung der Clamp-Spannungen V_{C1} und V_{C2}. Da die Realisierung kapazitiver Kommutierungen vom Typ 2 bei kleinen momentanen Phasenströmen infolge der kurzen Kommutierungsdauern und der deshalb notwendigen hohen zeitlichen Auflösung der Gatesignale aufwendig ist, und, um die Schaltverluste in den Hilfsschaltern T_{C1} und D_{C1} bzw. T_{C2} und D_{C2} zu minimieren, ist die Verwendung unterschiedlicher Regelalgorithmen vorteilhaft. Beispielsweise können der Fall 1 eines sinusförmigen Phasenstromes mit großem Effektivwert, z.B. bei Nennlast, und der Fall 2 eines sinusförmigen Phasenstromes mit kleinem Effektivwert, z.B. bei Lehrlauf, unterschieden werden.

Fall 1: Große momentane Phasenströme erfordern aufgrund der hohen gespeicherten Energie in der Einschaltentlastungsdrosselspule den aktiven Ladungsausgleich bei jeder kapazitiven Kommutierung. Es werden kapazitive Kommutierungen vom Typ 2 eingesetzt. Bei kleinen momentanen Phasenströmen werden dagegen kapazitive Kommutierungen vom Typ 1 angewendet. Der langfristige Ladungsausgleich kann allein durch eine geeignete Wahl der Schaltzeitpunkte für das Ausschalten der Hauptschalter (z.B. T₁₁ im obigen Beispiel) bei den kapazitiven Kommutierungen bei großen Phasenströmen gewährleistet werden.

Fall 2: Aufgrund der gegenüber Fall 1 kleineren Energien in der Einschaltentlastungsdrosselspule ist es möglich, bevorzugt kapazitive Kommutierungen vom Typ 1 anzuwenden, um Schaltverluste in den Hilfsschaltern (z.B. T_{C1}) zu vermeiden. Erst wenn die Clamp-Spannung (z.B. V_{C1}) aufgrund der ausschließlich positiven Ladungsbilanz der kapazitiven Kommutierungen vom Typ 1 und der induktiven Kommutierungen nach einer größeren Zahl von Kommutierungen einen oberen Grenzwert erreicht hat, wird eine kapazitive Kommutierung vom Typ 3 durchgeführt. Mit dieser Kommutierung wird die Clamp-Spannung (z.B. V_{C1}) auf ihren Sollwert zurückgeführt. Die zusätzlichen Schaltverluste des Hilfsschalters (z.B. T_{C1}) werden teilweise durch die Reduktion der Ausschaltverluste des Hauptschalters (z. B. T₁₁) durch Nullstromschalten bzw. Zero Current Switching kompensiert.

Die alternativen Ausführungsbeispiele gemäss Fig. 1 und Fig. 2 stellen beispielhafte Realisierungsmöglichkeiten für neue Hochleistungsstromrichter im Mittelspannungsbereich dar. Es sind jedoch für den Fachmann ohne weiteres Modifikationen und Veränderungen der Ausführungsbeispiele denkbar, die in den Schutzumfang der anhängenden Patentansprüche fallen.

## Patentansprüche

1. Schaltung zur Einschaltentlastung von abschaltbaren Leistungsschaltern in Dreipunkt-Stromrichtern, mit:
einer oberen Brückenhälfte mit:
N Paaren aus jeweils einem ersten abschaltbaren Leistungsschalter (T₁₁ bis T₃₁) und einem zweiten abschaltbaren Leistungsschalter (T₁₂ bis T₃₂), die in Reihe verbunden zwischen einem Pol (+) einer ersten Gleichspannungsquelle (V_{dc/2}) und einem Anschluss einer Last zusammen mit drei Paaren aus zwei den abschaltbaren Leistungsschaltern jeweils antiparallel liegenden, in Reihe verbundenen Dioden verbunden sind, wobei N = 1, 2, 3, ... ist,
N Paaren von weiteren Dioden (D₁₅ bis D₃₅), die zwischen einem anderen Pol (0) der ersten Gleichspannungsquelle (V_{dc/2}) und sowohl der Verbindung der N Paare des ersten abschaltbaren Leistungsschalters (T₁₁ bis T₃₁) und des zweiten abschaltbaren Leistungsschalters (T₁₂ bis T₃₂) als auch der Verbindung der N Paare von zwei antiparallel liegenden, in Reihe verbundenen Dioden verbunden sind, wobei N = 1, 2, 3, ... ist,
einer Einschaltentlastungsdrosselspule (L_{S1}), die zwischen dem einen Pol (+) der ersten Gleichspannungsquelle (V_{dc}) und dem ersten abschaltbaren Leistungsschalter (T₁₁) verbunden ist, und
einer Reihenschaltung aus einem Hilfsschalter (T_{C1}, D_{C1}) und einem Überspannungsbegrenzungskondensator (C_{C1}), die zwischen einer Verbindung zwischen der Einschaltentlastungsdrosselspule (L_{S1}) und dem ersten abschaltbaren Leistungsschalter (T₁₁) und dem anderen Pol (0) der ersten Gleichspannungsquelle (V_{dc/2}) verbunden ist, und,
einer unteren Brückenhälfte mit:
N Paaren aus jeweils einem dritten abschaltbaren Leistungsschalter (T₁₄ bis T₃₄) und einem vierten abschaltbaren Leistungsschalter (T₁₃ bis T₃₃), die in Reihe verbunden zwischen einem Pol (0) einer zweiten Gleichspannungsquelle (V_{dc/2}), der identisch dem anderen Pol (0) der ersten Gleichspannungsquelle (V_{dc/2}) ist, und einem Anschluss einer Last zusammen mit N Paaren aus zwei den abschaltbaren Leistungsschaltern jeweils antiparallel liegenden, in Reihe verbundenen Dioden verbunden sind, wobei N = 1, 2, 3, ... ist,
N Paaren von weiteren Dioden (D₁₆ bis D₃₆), die zwischen dem Pol (0) der zweiten Gleichspannungsquelle (V_{dc/2}) und sowohl der Verbindung der N Paare des dritten abschaltbaren Leistungsschalters (T₁₄ bis T₃₄) und des vierten abschaltbaren Leistungsschalters (T₁₃ bis T₃₃) als auch der Verbindung der N Paare von zwei antiparallel liegenden, in Reihe verbundenen Dioden verbunden sind, wobei N = 1, 2, 3, ... ist,
einer Einschaltentlastungsdrosselspule (L_{S2}), die zwischen dem einen Pol (-) der zweiten Gleichspannungsquelle (V_{dc/2}) und dem dritten abschaltbaren Leistungsschalter (T₁₁) verbunden ist, und
einer Reihenschaltung aus einem Überspannungsbegrenzungskondensator (C_{C2}) und einem Hilfsschalter (T_{C2}, D_{C2}), die zwischen einer Verbindung zwischen dem einem Pol (0) der zweiten Gleichspannungsquelle (V_{dc/2}) und der Verbindung zwischen der Einschaltentlastungsdrosselspule (L_{S1}) und dem dritten abschaltbaren Leistungsschalter (T₁₄) verbunden ist.

2. Schaltung zur Einschaltentlastung von abschaltbaren Leistungsschaltern in Dreipunkt-Stromrichtern, wobei
ein erster und ein zweiter abschaltbaren Leistungsschalter (T₁₁ bis T₃₁, T₁₂ bis T₃₂; T₁₄ bis T₃₄, T₁₃ bis T₃₃) als Bestandteil einer Brückenschaltung in Reihe verbunden zwischen einem Pol (+; -) einer Gleichspannungsquelle (V_{dc/2}) und einem Anschluss einer Last zusammen mit zwei jeweils antiparallel liegenden, in Reihe verbundenen Dioden,
eine weitere Diode (D₁₅ bis D₃₅; D₁₆ bis D₃₆), die zwischen einem anderen Pol (0) der Gleichspannungsquelle (V_{dc/2}) und sowohl der Verbindung des ersten abschaltbaren Leistungsschalters (T₁₁ bis T₃₁; T₁₄ bis T₃₄) und des zweiten abschaltbaren Leistungsschalters (T₁₂ bis T₃₂; T₁₃ bis T₃₃) als auch der Verbindung der zwei antiparallel liegenden, in Reihe verbundenen Dioden verbunden ist,
eine Einschaltentlastungsdrosselspule (L_{S1}; L_{S2}) zwischen dem einen Pol (+;-) der Gleichspannungsquelle (V_{dc}) und dem ersten abschaltbaren Leistungsschalter (T₁₁) verbunden ist, und
eine Reihenschaltung aus einem Überspannungsbegrenzungskondensator (C_{C1}; C_{C2}) und einem Hilfsschalter (T_{C1}, D_{C1}; T_{C2}, D_{C2}), zwischen einer Verbindung zwischen der Einschaltentlastungsdrosselspule (L_{S1}; L_{S2}) und dem ersten abschaltbaren Leistungsschalter (T₁₁; T₁₄) und dem einen Pol (+;-) der Gleichspannungsquelle (V_{dc/2}) verbunden ist.

3. Schaltung nach Anspruch 1 oder 2, wobei
der Hilfsschalter (T_{C1}, D_{C1}; T_{C2}, D_{C2}) entweder aus einem abschaltbaren Leistungsschalter (T_{C1}; T_{C2}) und einer diskreten antiparallelen Diode (D_{C1}; D_{C2}), aus rückwärts leitfähigen abschaltbaren Leistungsschaltern oder abschaltbaren Leistungsschaltern mit Inversdioden gebildet ist.

4. Verfahren zum Betrieb einer Schaltung gemäss einem der Ansprüche 1 bis 3 bei grossen effektiven Phasenströmen, dadurch gekennzeichnet, dass
bei kleinen momentanen Phasenströmen die Kommutierungen mit negativem Leistungsgradienten mit den folgenden Schritten durchgeführt werden:
Abschalten des Phasenstroms durch einen abschaltbaren Leistungsschalter (T₁₁) gegen eine Clamp-Spannung (V_{C1}), die über einen Überspannungsbegrenzungskondensator (C_{C1}) abfällt,
Kommutieren des Phasenstroms auf eine mit diesem abschaltbaren Leistungsschalter (T₁₁) verbundene Diode (D₁₅),
zeitgleiches Kommutieren des Stroms in einer Einschaltentlastungsdrosselspule (L_{S1}) in eine antiparallele Diode (D_{C1}) eines Hilfsschalters (T_{C1}, D_{C1}) und einen Überspannungsbegrenzungskondensator (C_{C1}),
nahezu lineares Abbauen eines Einschaltentlastungsdrosselspulenstroms (i_{LS1}) durch eine Spannungsdifferenz zwischen einer halben Zwischenkreisspannung (V_{dc/2}) und der Clamp-Spannung (V_{C1}), wobei die vor dem Schaltvorgang des abschaltbaren Leistungsschalters (T₁₁) in der Einschaltentlastungsdrosselspule (L_{S1}) gespeicherte Energie des ausgeschalteten Phasenstroms in den Überspannungsbegrenzungskondensator (C_{C1}) transferiert wird, und
passives Ausschalten der Diode (D_{C1}) des Hilfsschalters (T_{C1}, D_{C1}), wenn der Strom (i_{DC}, i_{CC1}) durch die Diode (D_{C1}) und den Überspannungsbegrenzungskondensator (C_{C1}) den Wert Null erreicht,
bei grossen momentanen Phasenströmen die Kommutierungen mit negativem Leistungsgradienten mit folgenden Schritten durchgeführt werden:
aktives Einschalten eines Hilfsschalters (T_{C1}),
nahezu lineares Abbauen eines Einschaltentlastungsdrosselspulenstroms (i_{LS1}) und Aufbauen eines negativen Stroms (i_{CC1}) durch einen Überspannungsbegrenzungskondensator (C_{C1}),
Ausschalten eines abschaltbaren Leistungsschalters (T₁₁), wenn der Betrag des Stroms (i_{CC1}) durch den Überspannungsbegrenzungskondensator (C_{C1}) auf einen vorbestimmten Teil des durch den abschaltbaren Leistungsschalter (T₁₁) auszuschaltenden Phasenstroms angewachsen ist,
Kommutieren des überschüssigen Einschaltentlastungsdrosselspulenstroms (i_{LS1}) in die Diode (D_{C1}) des Hilfsschalters (T_{C1}), wodurch der Hilfsschalter (T_{C1}) ausgeschaltet wird, und
passives Ausschalten der Diode (D_{C1}) des Hilfsschalters (T_{C1}), wenn der Strom (i_{CC1}) durch den Überspannungsbegrenzungskondensator (C_{C1}) Null wird,
und dass bei diesen Kommutierungen der Teil des durch den abschaltbaren Leistungsschalter (T₁₁) auszuschaltenden Phasenstromes, bei dessen Erreichen durch den Betrag des Stromes (i_{CC1}) durch den Überspannungsbegrenzungskondensator (C_{C1}) der abschaltbaren Leistungsschalter (T₁₁) ausgeschaltet wird, so bestimmt wird, dass ein langfristiger Ladungsausgleich am betreffenden Überspannungsbegrenzungskondensator (C_{C1}) erreicht wird,
und
die Kommutierungen mit positivem Leistungsgradienten unabhängig von der Grösse des Phasenstromes mit folgenden Schritten durchgeführt werden:
Einschalten eines abschaltbaren Leistungsschalters (T₁₁), so dass eine halbe Zwischenkreisspannung (V_{dc/2}) über eine Einschaltentlastungdrosselspule (L_{S1}) abfällt und der Phasenstrom linear von einer Diode (D₁₅) aus in den abschaltbaren Leistungsschalter (T₁₁) kommutiert,
passives Ausschalten der Diode (D₁₅) während eines Sperrverzögerungs-Prozesses und
Kommutieren eines Teils des Einschaltentlastungsdrosselnspulenstroms (i_{LS1}) in eine Diode (D_{C1}) eines Hilfsschalters (T_{C1}, D_{C1}) sowie einen Clamp-Kondensator (C_{C1}).

5. Verfahren zum Betrieb einer Schaltung gemäss einem der Ansprüche 1 bis 3 bei kleinen effektiven Phasenströmen, dadurch gekennzeichnet, dass
die Kommutierungen mit negativem Leistungsgradienten unabhängig von der Grösse des Phasenstroms mit folgenden Schritten durchgeführt werden, wenn die betreffende Clamp-Spannung unterhalb eines vorbestimmten Grenzwerts liegt: Abschalten des Phasenstroms durch einen abschaltbaren Leistungsschalter (T₁₁) gegen eine Clamp-Spannung (V_{C1}), die über einen Überspannungsbegrenzungskondensator (C_{C1}) abfällt,
Kommutieren des Phasenstroms auf eine zu mit diesem abschaltbaren Leistungsschalter (T₁₁) verbundene Diode (D₁₅),
zeitgleiches Kommutieren des Stroms in einer Einschaltentlastungsdrosselspule (L_{S1}) in eine antiparallele Diode (D_{C1}) eines Hilfsschalters (T_{C1}, D_{C1}) und einen Überspannungsbegrenzungskondensator (C_{C1}),
nahezu lineares Abbauen eines Einschaltentlastungsdrosselspulenstroms (i_{LS1}) durch eine Spannungsdifferenz zwischen einer halben Zwischenkreisspannung (V_{dc/2}) und der Clamp-Spannung (V_{C1}), wobei die vor dem Schaltvorgang des abschaltbaren Leistungsschalters (T₁₁) in der Einschaltentlastungsdrosselspule (L_{S1}) gespeicherte Energie des ausgeschalteten Phasenstroms in den Überspannungsbegrenzungskondensator (C_{C1}) transferiert wird, und
passives Ausschalten der Diode (D_{C1}) des Hilfsschalters (T_{C1}, D_{C1}), wenn der Strom (i_{DC}, i_{CC1}) durch die Diode (D_{C1}) und den Überspannungsbegrenzungskondensator (C_{C1}) den Wert Null erreicht,
die Kommutierungen mit negativem Leistungsgradienten unabhängig von der Grösse des Phasenstromes mit folgenden Schritten durchgeführt werden, wenn die betreffende Clamp-Spannung oberhalb eines vorbestimmten oberen Grenzwerts liegt:
aktives Einschalten eines Hilfsschalters (T_{C1}),
nahezu lineares Abbauen eines Einschaltentlastungsdrosselspulenstromes (i_{LS1}) und Aufbauen eines negativen Stromes (i_{CC1}) durch einen Überspannungsbegrenzungskondensator (C_{C1}), zeitgleiches Ausschalten des Hilfsschalters (T_{C1}) und eines abschaltbaren Leistungsschalters (T₁₁), wenn der Betrag des Stromes (i_{CC1}) durch den Überspannungsbegrenzungskondensator (C_{C1}) einen vorbestimmten Wert erreicht hat, der grösser als der Wert des durch den abschaltbaren Leistungsschalter (T₁₁) auszuschaltenden Phasenstromes ist,
Kommutierung des überschüssigen Einschaltentlastungsdrosselspulenstromes (i_{LS1}) auf eine Diode (D₁₅) und eine antiparallele Diode (D₁₁) eines abschaltbaren Leistungsschalters (T₁₁),
linearer Abbau des überschüssigen Einschaltentlastungsdrosselspulenstromes (i_{LS1}) durch die halbe Zwischenkreisspannung (V_{dc/2}) und passives Ausschalten der antiparallelen Diode (D₁₁) des abschaltbaren Leistungsschalters (T₁₁), wenn der überschüssige Einschaltentlastungsdrosselspulenstrom (i_{LS1}) Null wird, und
bei diesem Kommutierungen der Betrag des Stromes (i_{CC1}) durch den Überspannungsbegrenzungskondensator (C_{C1}), bei dessen Erreichen der Hilfsschalter (T_{C1}) und der abschaltbaren Leistungsschalter (T₁₁) zeitgleich ausgeschaltet werden, so bestimmt wird, dass die betreffende Clamp-Spannung während einer solchen Kommutierung auf einen vorbestimmten Wert unterhalb ihres vorbestimmten oberen Grenzwertes zurückgeführt wird, und
die Kommutierungen mit positivem Leistungsgradienten unabhängig von der Grösse des Phasenstromes mit folgenden Schritten durchgeführt werden:
Einschalten eines abschaltbaren Leistungsschalters (T₁₁), so dass eine halbe Zwischenkreisspannung (V_{dc/2}) über eine Einschaltentlastungdrosselspule (L_{S1}) abfällt und der Phasenstrom linear von einer Diode (D₁₅) aus in den abschaltbaren Leistungsschalter (T₁₁) kommutiert,
passives Ausschalten der Diode (D₁₅) während eines Sperrverzögerungs-Prozesses und
Kommutieren eines Teils des Einschaltentlastungsdrosselnspulenstroms (i_{LS1}) in eine Diode (D_{C1}) eines Hilfsschalters (T_{C1}, D_{C1}) sowie einen Clamp-Kondensator (C_{C1}).

6. Schaltung nach einem der Ansprüche 1 bis 3, wobei
der abschaltbare Leistungsschalter ein IGCT(Integrated Gate Commutated Thyristor), ein IGBT (Insulated-Gate-Bipolartransistor) oder ein SiC-MOSFET (SiC-Metall-Oxid-Halbleiter-Feldeffekttransistor) ist.

7. Verfahren nach einem der Ansprüche 4 oder 5, wobei
der abschaltbare Leistungsschalter ein IGCT(Integrated Gate Commutated Thyristor), ein IGBT (Insulated-Gate-Bipolartransistor) oder ein SiC-MOSFET (SiC-Metall-Oxid-Halbleiter-Feldeffekttransistor) ist.
